Europäisches Patentamt

European Patent Office

Office européen des brevets

(11) Veröffentlichungsnummer: **0 284 823**

**A2**

(12) **EUROPÄISCHE PATENTANMELDUNG**

(21) Anmeldenummer: **88103419.3**

(22) Anmeldetag: **05.03.88**

(51) Int. Cl.⁴: **H02B 1/08**

(30) Priorität: **30.03.87 DE 3710567**

(43) Veröffentlichungstag der Anmeldung:
**05.10.88 Patentblatt 88/40**

(84) Benannte Vertragsstaaten:
**AT BE CH DE ES FR GB GR IT LI LU NL SE**

(71) Anmelder: **Rittal-Werk Rudolf Loh GmbH & Co. KG**
**Auf dem Stützelberg**
**D-6348 Herborn(DE)**

(72) Erfinder: **Debus, Jürgen**
**Am Ebersbach 50**
**D-6334 Dietzhölztal 1(DE)**
Erfinder: **Lehr, Lothar**
**Dresselndorfer Strasse 16**
**D-5909 Burbach(DE)**

(74) Vertreter: **Vogel, Georg**
**Hermann-Essig-Strasse 35**
**D-7141 Schwieberdingen(DE)**

(54) **Sockel für einen Schaltschrank.**

(57) Die Erfindung betrifft einen Sockel für einen Schaltschrank, der aus vier winkelförmigen Eckstücken, mindestens zwei Querblenden und mindestens zwei Längsblenden zu einem Rahmen zusammengesetzt ist, bei dem die Eckstücke zwei im rechten Winkel zueinander stehende vertikale Außenwände aufweisen, bei dem an den freien vertikalen Kanten der Außenwände vertikale Blenden-Befestigungsflansche mit Blenden-Befestigungsbohrungen und an den horizontalen Kanten der der Längsblende zugekehrten Außenwand horizontale Schrank-Befestigungsflansche mit Schrank-Befestigungsbohrungen rechtwinklig eingebogen sind und bei dem die boxartig ausgebildeten Quer-und Längsblenden an ihren Stoßstellen zu den Eckstücken so mit den Blenden-Befestigungsflanschen verbindbar sind, daß sie bündig an die Außenflächen der Eckstücke anschließen. Die Formstabilität und Verwindungssteifigkeit des Sockels wird dadurch wesentlich erhöht, daß an den freien Kanten der Schrank-Befestigungsflansche zumindest im Bereich der Blenden-Befestigungsflansche für die Querblenden vertikale Verbindungsflansche rechtwinklig eingebogen sind, die bei der Anbringung der Querblenden an den Blenden-Befestigungsflanschen mit diesen verbindbar sind.

## Sockel für einen Schaltschrank

Die Erfindung betrifft einen Sockel für einen Schaltschrank, der aus vier winkelförmigen Eckstücken, mindestens zwei Querblenden und mindestens zwei Längsblenden zu einem Rahmen zusammengesetzt ist, bei dem die Eckstücke zwei im rechten Winkel zueinander stehende vertikale Außenwände aufweisen, bei dem an den freien vertikalen Kanten der Außenwände vertikale Blenden-Befestigungsflansche mit Blenden-Befestigungsbohrungen und an den horizontalen Kanten der der Längsblende zugekehrten Außenwand horizontale Schrank-Befestigungsflansche mit Schrank-Befestigungsbohrungen rechtwinklig eingebogen sind und bei dem die boxartig ausgebildeten Quer- und Längsblenden an ihren Stoßstellen zu den Eckstücken so mit den Blenden-Befestigungsflanschen verbindbar sind, daß sie bündig an die Außenflächen der Eckstücke anschließen.

Ein derartiger Sockel ist aus der DE-PS 34 12 291 bekannt und hat den Vorteil, daß die Quer-und Längsblenden und die Eckstücke als Bausatz leicht montier-und demontierbar ist. Es hat sich nun gezeigt, daß gerade bei großen, schweren Schaltschränken der Sockel im Bereich der Eckstücke nicht die erforderliche Stabilität aufweist. Die beiden vertikalen Außenwände des Eckstückes behalten ihre rechtwinklige Stellung nicht bei und auch die Schrank-Befestigungsflansche verlassen bei Belastung ihre horizontale Ausrichtung. Dies hat zur Folge, daß sich der Sockel verzieht und keine eindeutige Befestigungsebene mehr für den Schaltschrank und selbst auch keine eindeutige Aufstellebene mehr bietet.

Es ist Aufgabe der Erfindung, einen Sockel der eingangs erwähnten Art zu schaffen, der durch einfache Maßnahmen an den Eckstücken eine wesentlich höhere Stabilität und Verwindungssteifigkeit erhält.

Diese Aufgabe wird nach der Erfindung dadurch gelöst, daß an den freien Kanten der Schrank-Befestigungsflansche zumindest im Bereich der Blenden-Befestigungsflansche für die Querblenden vertikale Verbindungsflansche rechtwinklig eingebogen sind, die bei der Anbringung der Querblenden an den Blenden-Befestigungsflanschen mit diesen verbindbar sind.

Durch die Verbindung der Schrank-Befestigungsflansche mit den Blenden-Befestigungsflanschen wird ein stabiler Hohlkörper geschaffen, bei dem nicht nur die Außenwände des Eckstückes zueinander, sondern auch die Schrank-Befestigungsflansche zu den Außenwänden eindeutig festgelegt sind und bei dem sich diese Zuordnungen auch bei großen, ungleichen Belastungen nicht verändern. Die Eckstücke werden dadurch nicht teurer. Die Verbindungsflansche lassen sich bei der Herstellung des Eckstückes im Stanz-und Biegeverfahren ohne Mehraufwand anbringen und in die richtige Position bringen, so daß sie dann beim Anbringen der Querblenden mit den Blenden-Befestigungsschrauben mit den Blenden-Befestigungsflanschen verbunden werden können. Dazu reicht aus, daß die Verbindungsflansche mit mindestens einer Verbindungsaufnahme versehen sind, die mit einer Blenden-Befestigungsbohrung des zugekehrten Blenden-Befestigungsflansches fluchtet.

Diese Schraubverbindungen lassen sich dadurch vereinfachen und leichter herstellen, wenn vorgesehen ist, daß die Verbindungsaufnahmen als Gewindebohrungen für Befestigungsschraube ausgebildet sind oder daß im Bereich der als Bohrung ausgebildeten Verbindungsaufnahme auf den den Blenden-Befestigungsflanschen abgekehrten Seiten der Verbindungsflansche Muttern angebracht sind, der Gewindeaufnahmen mit den als Bohrung ausgebildeten Verbindungsaufnahmen fluchten.

Damit die Eckstücke nach wie vor symmetrisch ausgelegt werden können, sieht eine weitere Ausgestaltung vor, daß sich die Verbindungsflansche nur über einen Teil der Höhe der Blenden-Befestigungsflansche erstrecken, die gleich oder kleiner ist als die halbe Höhe des Sockels, und daß die einander zugeordneten Verbindungsflansche eines Eckstückes gleiche Abmessungen aufweisen.

Der Zugang zu den Schraubverbindungen wird im Eckstück dadurch erleichtert, daß die horizontalen Abmessungen der Blenden-Befestigungsflansche und der Verbindungsflansche gleich groß sind.

Zur Versteifung der Schrank-Befestigungsflansche ist vorgesehen, daß die Schrank-Befestigungsflansche außerhalb der Verbindungsflansche mit rechtwinklig eingebogenen Verstärkungsflanschen versteift sind, deren vertikale Abmessungen kleiner sind als die vertikalen Abmessungen der Verbindungsflansche.

Die Außenwand des Eckstückes ohne Schrank-Befestigungsflansch läßt sich dadurch versteifen, daß die Schrank-Befestigungsflansche an den Seiten, die an die der Querblende zugeordneten Außenwand des Eckstückes angrenzen, mit Ausnehmungen für an der Außenwand rechtwinklig eingebogene horizontale Verstärkungsflansche versehen sind. Die Ausnehmungen in den Schrank-Befestigungsflanschen schaffen Platz für diese Verstärkungsflansche.

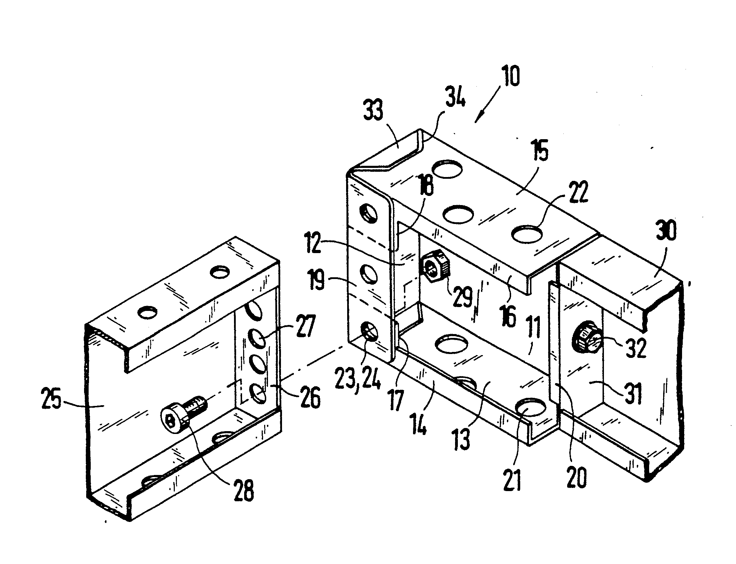

Die Erfindung wird an einem in der Zeichnung dargestellten Ausführungsbeispiel näher erläutert.

Das Kernstück des Sockels ist das Eckstück 10, das aus einem Plattenmaterial gestanzt und gebogen wird. Die beiden vertikalen Außenwände 11 und 12 des Eckstückes 10 stehen im rechten Winkel zueinander. An den freien vertikalen Kanten der Außenwände 11 und 12 sind die vertikalen Blenden-Befestigungsflansche 19 und 20 nach innen eingebogen. Die Blenden-Befestigungsflansche 19 und 20 tragen Blenden-Befestigungsbohrungen 23, wie an dem Blenden-Befestigungsflansch 19 zu sehen ist.

An den horizontalen Kanten der der Längsblende 30 zugekehrten Außenwand 11 sind die horizontalen Schrank-Befestigungsflansche 13 und 15 rechtwinklig nach innen eingebogen. Diese Schrank-Befestigungsflansche 13 und 15 tragen die Schrank-Befestigungsbohrungen 21 und 22, über die der Schaltschrank mit dem Sockel verbunden, vorzugsweise verschraubt werden kann.

Die der Außenwand 12 zugekehrten Seiten der Schrank-Befestigungsflansche 13 und 15 tragen Ausnehmungen 33 für die an den horizontalen Kanten der Außenwand 12 rechtwinklig nach innen eingebogenen, horizontalen Verstärkungsflanschen 34.

Die Schrank-Befestigungsflansche 13 und 15 sind im Bereich des Blenden-Befestigungsflansches 19 für die Querblende 25 mit rechtwinklig eingebogenen, vertikalen Verbindungsflanschen 17 und 18 versehen. Diese Verbindungsflansche 17 und 18 werden, wie die schmäleren Verstärkungsflansche 14 und 16 an der freien Kante der Schrank-Befestigungsflansche 13 und 15 abgekantet.

Die Verbindungsflansche 17 und 18 tragen mindestens eine Verbindungsaufnahme 24, die mit einer Blenden-Befestigungsbohrung 23 des Blenden-Befestigungsflansches 19 fluchtet. Wird die boxartige Querblende 25 mit dem Eckstück 10 verbunden, dann werden die Befestigungsschrauben 28 durch die Bohrungen 27 des Befestigungsflansches 26 der Querblende 25, die Blenden-Befestigungsbohrungen 23 des Blenden-Befestigungsflansches 19 und die als Bohrungen ausgebildeten Verbindungsaufnahmen 24 der Verbindungsflansche 17 und 18 geführt und mit den Muttern 29 verschraubt. Dabei werden die Schrank-Befestigungsflansche 13 und 15 durch den Blenden-Befestigungsflansch 19 stabilisiert und in ihrer horizontalen Stellung eindeutig gehalten. Außerdem stabilisieren die Schrank-Befestigungsflansche 13 und 15 über den Blenden-Befestigungsflansch 19 die beiden Außenwände 11 und 12 in ihren Stellungen. Das Eckstück 10 erhält damit eine wesentlich höhere Stabilität und Verwindungssteifigkeit, die sich voll auf den Sockel überträgt.

In gleicher Weise ließe sich auch der Blenden-Befestigungsflansch 20 über Verbindungsflansche mit den Schrank-Befestigungsflanschen 13 und 15 verbinden. Die Befestigungsschrauben 32 würden dabei die Verbindungsflansche, die an den Schrank-Befestigungsflanschen 13 und 15 abgekantet werden, mit dem Blenden-Befestigungsflansch 20 des Eckstückes 10 und dem Befestigungsflansch 31 der boxartigen Längsblende 30 verbinden.

Die Montage und Demontage des Sockels läßt sich dadurch erleichtern und vereinfachen, wenn die Verbindungsaufnahmen 24 der Verbindungsflansche 17 und 18 bzw. 20 als Gewindebohrungen ausgebildet sind. Die Muttern 29 entfallen dann. Es können jedoch auch Muttern 29 im Bereich der als Bohrungen ausgebildeten Verbindungsaufnahmen 24 mit den Verbindungsflanschen 17 und 18 - und zwar auf der dem Blenden-Befestigungsflansch 19 abgekehrten Seite der Verbindungsflansche - verbunden werden. Die Gewindeaufnahmen der Muttern 29 fluchten dabei mit den Verbindungsaufnahmen 24 der Verbindungsflansche 17 und 18.

Die erhöhte Stabilität und Verwindungssteifigkeit der Eckstücke 10 des Sockels wird bei gleichbleibender Dicke des Ausgangsmaterials allein durch die zusätzlichen Verbindungsflansche erreicht, die das Eckstück 10 im Verbindungszustand des Sockels zu einem formstabilen Hohlkörper vervollständigen.

## Ansprüche

1. Sockel für einen Schaltschrank, der aus vier winkelförmigen Eckstücken, mindestens zwei Querblenden und mindestens zwei Längsblenden zu einem Rahmen zusammengesetzt ist, bei dem die Eckstücke zwei im rechten Winkel zueinander stehende vertikale Außenwände aufweisen, bei dem an den freien vertikalen Kanten der Außenwände vertikale Blenden-Befestigungsflansche mit Blenden-Befestigungsbohrungen und an den horizontalen Kanten der der Längsblende zugekehrten Außenwand horizontale Schrank-Befestigungsflansche mit Schrank-Befestigungsbohrungen rechtwinklig eingebogen sind und bei dem die boxartig ausgebildeten Quer-und Längsblenden an ihren Stoßstellen zu den Eckstücken so mit den Blenden-Befestigungsflanschen verbindbar sind, daß sie bündig an die Außenflächen der Eckstücke anschließen,
dadurch gekennzeichnet,
daß an den freien Kanten der Schrank-Befestigungsflansche (13,15) zumindest im Bereich der Blenden-Befestigungsflansche (19) für die Querblenden (25) vertikale Verbindungsflansche (17,18) rechtwinklig eingebogen sind, die bei der Anbringung der Querblenden (25) an den Blenden-Befestigungsflanschen (19) mit diesen verbindbar sind.

2. Sockel nach Anspruch 1,
dadurch gekennzeichnet,
daß die Verbindungsflansche (17,18) mit mindestens einer Verbindungsaufnahme (24) versehen sind, die mit einer Blenden-Befestigungsbohrung (23) des zugekehrten Blenden-Befestigungsflansches (19) fluchtet.

3. Sockel nach Anspruch 2,
dadurch gekennzeichnet,
daß die Verbindungsaufnahmen (24) als Gewindebohrungen für Befestigungsschraube (28) ausgebildet sind.

4. Sockel nach Anspruch 2,
dadurch gekennzeichnet,
daß im Bereich der als Bohrung ausgebildeten Verbindungsaufnahme (24) auf den den Blenden-Befestigungsflanschen (19) abgekehrten Seiten der Verbindungsflansche (17,18) Muttern (29) angebracht sind, der Gewindeaufnahmen mit den als Bohrung ausgebildeten Verbindungsaufnahmen (24) fluchten.

5. Sockel nach einem der Ansprüche 1 bis 4,
daß sich die Verbindungsflansche (17,18) nur über einen Teil der Höhe der Blenden-Befestigungsflansche (19) erstrecken, die gleich oder kleiner ist als die halbe Höhe des Sockels, und
daß die einander zugeordneten Verbindungsflansche (17,18) eines Eckstückes (10) gleiche Abmessungen aufweisen.

6. Sockel nach Anspruch 5,
dadurch gekennzeichnet,
daß die horizontalen Abkmessungen der Blenden-Befestigungsflansche (19) und der Verbindungsflansche (17,18) gleich groß sind.

7. Sockel nach Anspruch 6,
dadurch gekennzeichnet,
daß die Schrank-Befestigungsflansche (13,15) außerhalb der Verbindungsflansche (17,18) mit rechtwinklig eingebogenen Verstärkungsflanschen (14,16) versteift sind, deren vertikale Abmessungen kleiner sind als die vertikalen Abmessungen der Verbindungsflansche (17,18).

8. Sockel nach einem der Ansprüche 1 bis 7,
dadurch gekennzeichnet,
daß die Schrank-Befestigungsflansche (13,15) an den Seiten, die an die der Querblende (25) zugeordneten Außenwand (12) des Eckstückes (10) angrenzen, mit Ausnehmungen (34) für an der Außenwand (12) rechtwinklig eingebogene horizontale Verstärkungsflansche (33) versehen sind.

9. Sockel nach einem der Ansprüche 1 bis 8,
dadurch gekennzeichnet,
daß die der Längsblende (30) zugekehrten horizontalen Kanten der Schrank-Befestigungsflansche (13,15) mit rechtwinklig eingebogenen, vertikalen Verbindungsflanschen versehen sind, die mit dem Anbringen der Längsblende (30) mit dem zugekehrten Blenden-Befestigungsflansch (20) des Eckstückes (10) und einem Befestigungsflansch (31) der boxartigen Längsblende (30) verschraubt (32) werden.